# EUROPEAN PATENT APPLICATION

(11) **EP 1 193 330 A2**
(43) Date of publication of application: **03.04.2002**
(21) Application number: 01121793.2
(22) Date of filing: 20.09.2001
(51) Int. Cl.: C25D 5/02, C25D 5/54, C25D 3/38, C25D 7/06, C25D 7/12

(54) **Plating apparatus and plating method for substrate**

(30) Priority: 20.09.2000 JP 2000285522
(71) Applicant: EBARA CORPORATION, Ohta-ku, Tokyo (JP); Kabushiki Kaisha Toshiba, Tokyo (JP)
(72) Inventor: Kimura, Norio, Fujisawa-shi, Kanagawa-ken (JP); Mishima, Koji, Fujisawa-shi, Kanagawa-ken (JP); Kunisawa, Junji, Yamato-shi, Kanagawa-ken (JP); Inoue, Hiroaki, Machida-shi, Tokyo (JP); Makino, Natsuki, Fujisawa-shi, Kanagawa-ken (JP); Matsuda, Tetsuo, Yokohama-shi, Kanagawa-ken (JP); Kaneko, Hisashi, Fujisawa-shi, Kanagawa-ken (JP)
(74) Representative: Wagner, Karl H., Dipl.-Ing.

(57) **Abstract**

A substrate is plated with a metal film of uniform thickness only in a limited area thereof which is to be plated. A substrate plating apparatus has a substrate holder for holding a substrate and a plating cell for plating a portion of a surface, to be plated, of the substrate held by the substrate holder. The plating cell has an anode disposed so as to cover the portion of the surface, to be plated, of the substrate held by the substrate holder, a cathode for supplying a current to the surface, to be plated, of the substrate in such a state that the cathode is brought into contact with the substrate, a plating liquid supplying device for supplying a plating liquid between the anode and the surface, to be plated, of the substrate, and a power source for applying a voltage between the anode and the cathode.

## Description

### BACKGROUND OF THE INVENTION

### Field of the Invention:

The present invention relates to a plating apparatus and a plating method for plating a substrate, and more particularly to a plating apparatus and a plating method for filling a metal such as copper (Cu) or the like in fine interconnect patterns (recesses) formed on the surface of the substrate such as a semiconductor substrate or the like.

### Description of the Related Art:

One known process of forming interconnections on semiconductor devices is a damascene process for filling a metal, i.e., an electric conductor, in interconnect trenches and contact holes. According to the damascene process, interconnect trenches and contact holes formed in an inter-layer dielectric are filled with a metal such as aluminum, or silver or copper in recent years, and then any excess metal deposits are removed by a chemical mechanical polishing (CMP) process to planarize the inter-layer dielectric.

It has increasingly become popular in recent years to use copper, which has low electric resistivity and highly resistant to electromigration, as a metal material for forming interconnect circuits on semiconductor substrates, in place of aluminum or aluminum alloy. Such copper interconnections can be made by CVD, sputtering, or plating. In any case, a copper film is deposited on the almost entire surface of the substrate and then any undesired copper deposits are removed from the substrate by the CMP process.

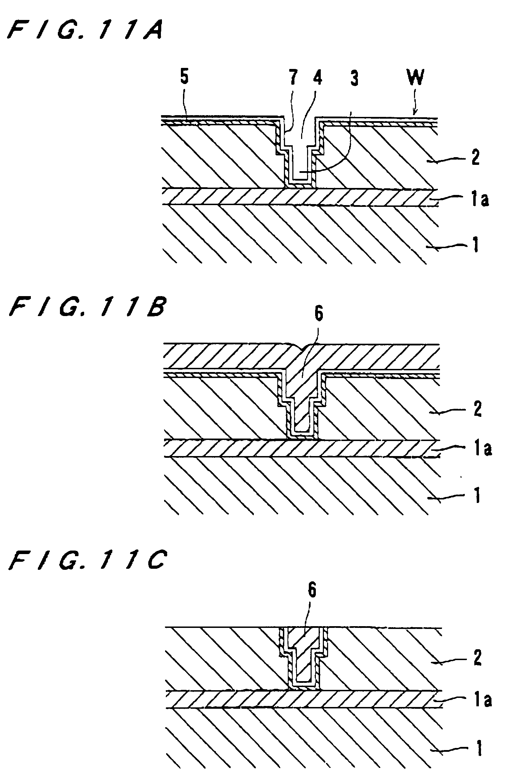

FIGS. 11A through 11C of the accompanying drawings show successive steps of forming a copper interconnection. As shown in FIG. 11A, an insulating film 2 of SiO₂ is deposited on a conductive layer 1a on a semiconductor base 1 with semiconductor devices formed thereon, and a contact hole 3 and a trench 4 for an interconnection are formed in the insulating film 2 by lithographic and etching technology. Then, a barrier layer 5 of TaN or the like is deposited by sputtering on the surface formed so far, and a copper seed layer 7 is formed as an electric supply layer for electroplating on the barrier layer 5 by sputtering.

As shown in FIG. 11B, the surface formed so far of a semiconductor substrate W is plated with copper, filling the contact hole 3 and the trench 4 for the interconnection with copper and depositing a copper film 6 on the insulating film 2. Thereafter, the copper film 6 on the insulating film 2 is removed by the CMP process, making the surface of the copper film 6 filled in the contact hole 3 and the trench 4 for the interconnection lie flush with the surface of the insulating film 2. In this manner, an interconnection composed of the copper film 6 is produced as shown in FIG. 11C.

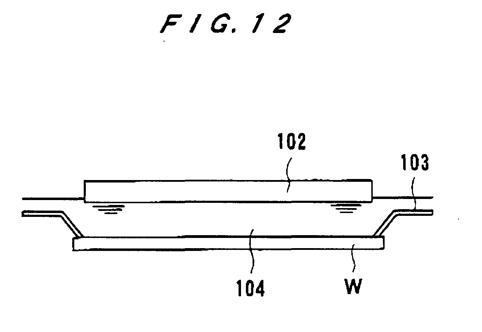

According to a conventional process of plating such a substrate, as shown in FIG. 12 of the accompanying drawings, a substrate W such as semiconductor substrate and an anode 102 which has substantially the same area as the substrate W are placed in confronting relation to each other in a plating liquid 104. A plating current is then supplied to flow between the anode 102 and the seed layer 7 (see FIG. 11A) of the substrate W which is connected to cathode electrodes 103, thus forming a plated metal film such as the copper film 6 (see FIG. 11B) on the surface of the seed layer 7.

According to the conventional plating process, however, since the substrate W and the anode 102 are dipped in the plating liquid 104 and disposed in facing relation to each other, the electric field intensity between the substrate W serving as the cathode and the anode 102 is not uniform over the entire surface, to be plated, of the substrate W, failing to form a plated film of uniform thickness. In addition, since a plated film tends to be formed in areas which are not required to be plated, the unnecessary plated film subsequently needs to be removed by polishing.

### SUMMARY OF THE INVENTION

It is therefore an object of the present invention to provide a plating apparatus and a plating method for plating a substrate to form a plated film only in a limited area thereof which is to be plated and to form a plated metal film of uniform thickness on the substrate.

According to the present invention, there is provided a plating apparatus for plating a substrate, comprising: a substrate holder for holding a substrate; and a plating cell for plating a portion of a surface, to be plated, of the substrate held by the substrate holder; wherein the plating cell comprises: an anode disposed so as to cover the portion of the surface, to be plated, of the substrate held by the substrate holder; a cathode for supplying a current to the surface, to be plated, of the substrate in such a state that the cathode is brought into contact with the substrate; a plating liquid supplying device for supplying a plating liquid between the anode and the surface, to be plated, of the substrate; and a power source for applying a voltage between the anode and the cathode.

The plating liquid is supplied between the anode and the portion of the surface, to be plated, of the substrate which is covered with the anode to electrically plate the substrate. The area of the anode is made identical to the surface area, to be plated, of the substrate, so that the plating liquid can be held in only the surface area, to be plated, of the substrate to form a plated film on the surface area of the substrate on which the plating liquid is held. Since the plating liquid is supplied between the anode and the surface, to be plated, of the substrate, it is easy to uniformize the electric field intensity between the anode and the surface (seed layer), to be plated, of the substrate unlike the conventional plating apparatus in which the anode and the substrate is disposed in facing relation to each other in the plating liquid, making it possible to form a plated film of uniform thickness in only the surface area, to be plated, of the substrate.

The plating apparatus wherein the plating cell further comprising a plating liquid holding member provided on a lower surface of the anode. The plating liquid holding member can reliably hold the plating liquid supplied between the anode and the portion of the surface, to be plated, of the substrate which is covered with the anode.

The plating liquid holding member comprises a plate-like porous material. The porous material may be a porous ceramic material, for example.

The plating liquid holding member comprises a plurality of porous materials combined with each other. The plating liquid holding member may be made of a coarse porous material and a dense porous material such that the thickness of a plated film in the area of the surface, to be plated, of the substrate which is confronted by the coarse porous material is increased, and the thickness of a plated film in the area of the surface, to be plated, of the substrate which is confronted by the dense porous material is reduced.

The plating apparatus wherein the plating cell further comprising a sealing member having a opening formed therein; wherein the anode and the plating liquid holding member are disposed within the sealing member, and a sealed space surrounded by the sealing member is formed when the lower opening end is pressed against the surface, to be plated, of the substrate. The plating liquid is thus held in only the surface area, to be plated, of the substrate, i.e., in the sealed space, for thereby forming a plated film only in the surface area where the plating liquid is held.

The cathode electrode is disposed on the outer circumferential surface of the sealing member. As a result, the cathode electrode is prevented from being corroded by the plating liquid, and no plated metal film will be deposited on the surface of the cathode electrode.

The plating liquid supplying device has a plating liquid supply/discharge hole defined through the anode and the plating liquid holding member, and communicated with the sealed space. The plating liquid is thus reliably introduced through the plating liquid supply/discharge hole into the sealed space.

The anode has a discharge hole defined therein for discharging a gas from the sealed space. Consequently, the gas in the sealed space can smoothly be replaced with the plating liquid, and the gas is prevented from remaining in the plating liquid, making it possible to form a high-quality plated film on the substrate.

The plating liquid holding member is positioned so as to hold the supplied plating liquid between the plating liquid holding member and the surface, to be plated, of the substrate, under surface tension of the plating liquid. With the above arrangement, the plating cell can basically be constructed of two components, i.e., the anode and the plating liquid holding member.

The plating liquid supplying device has a plating liquid supply nozzle for supplying the plating liquid between the plating liquid holding member and the surface, to be plated, of the substrate. The plating liquid supply nozzle is capable of supplying the plating liquid between the plating cell, which is basically made up of the anode and the plating liquid holding member, and the surface, to be plated, of the substrate.

A plurality of plating cells are arrayed in such a manner that the plating cells face the surface, to be plated, of the substrate. The plating cells arrayed in such a manner that the plating cells face the surface, to be plated, of the substrate are able to simultaneously form plated films in respective required areas of the surface, to be plated, of the substrate.

The apparatus further comprises a plating cell holder for holding the plating cells in common.

Each of the plating cells is arranged so as to individually control a plating current flowing between the anode and the surface, to be plated, of the substrate facing the anodes. Thus, the thicknesses of plated films can individually be controlled at the respective plating cells.

According to the present invention, there is also provided a plating method for plating a substrate, comprising: covering a portion of a surface, to be plated, of the substrate with an anode; holding a plating liquid between the anode and the surface, to be plated, of the substrate; and applying a voltage between the anode and the surface, to be plated, of the substrate to plate the portion of the surface, to be plated, of the substrate covered with the anode.

Since the plating liquid is held between the anode and the portion of the surface, to be plated, of the substrate which is covered with the anode, it is possible to form a plated metal film of uniform thickness in a desired area of the surface, to be plated, of the substrate.

The anode and the plating liquid holding member are disposed within a sealing member having a opening formed therein, and the plating liquid is held in a sealed space formed by the lower opening end which is pressed against the surface, to be plated, of the substrate.

The plating liquid holding member is disposed in close proximity to the surface, to be plated, of the substrate to hold the plating liquid under surface tension between the plating liquid holding member and the surface, to be plated, of the substrate.

The above and other objects, features, and advantages of the present invention will become apparent from the following description when taken in conjunction with the accompanying drawings which illustrate preferred embodiments of the present invention by way of example.

### BRIEF DESCRIPTION OF THE DRAWINGS

FIG. 1 is a schematic view of a substrate plating apparatus according to a first embodiment of the present invention;
FIG. 2 is an enlarged cross-sectional view of a portion of the substrate plating apparatus shown in FIG. 1;
FIG. 3A is a plan view showing a constitutional example of a substrate plating apparatus according to a second embodiment of the present invention;
FIG. 3B is a cross-sectional view taken along line A - A of FIG. 3A;
FIG. 4 is a schematic view of a substrate plating apparatus according to a third embodiment of the present invention;
FIG. 5 is an enlarged cross-sectional view of a portion of the substrate plating apparatus shown in FIG. 4;
FIG. 6 is an enlarged cross-sectional view of a portion of a substrate plating apparatus according to a fourth embodiment of the present invention;
FIG. 7 is an enlarged cross-sectional view of a portion of a substrate plating apparatus according to a fifth embodiment of the present invention;
FIG. 8A is an enlarged fragmentary cross-sectional view of a plated film formed by a conventional substrate plating apparatus;
FIG. 8B is an enlarged fragmentary cross-sectional view of a plated film formed by a substrate plating apparatus according to the present invention;
FIG. 8C is an enlarged fragmentary cross-sectional view of an interconnection produced from the plated film by a CMP process;
FIG. 9 is a plan view showing a constitutional example of a substrate processing system which incorporates a substrate plating apparatus according to the present invention;
FIG. 10 is a cross-sectional view of a polishing apparatus in the substrate processing system shown in FIG. 9;
FIGS. 11A through 11C are cross-sectional views showing successive steps of forming a copper interconnection in a semiconductor device; and
FIG. 12 is a schematic view showing a conventional substrate plating apparatus.

### DETAILED DESCRIPTION OF THE PREFERRED EMBODIMENTS

Like or corresponding parts are denoted by like or corresponding reference characters throughout views.

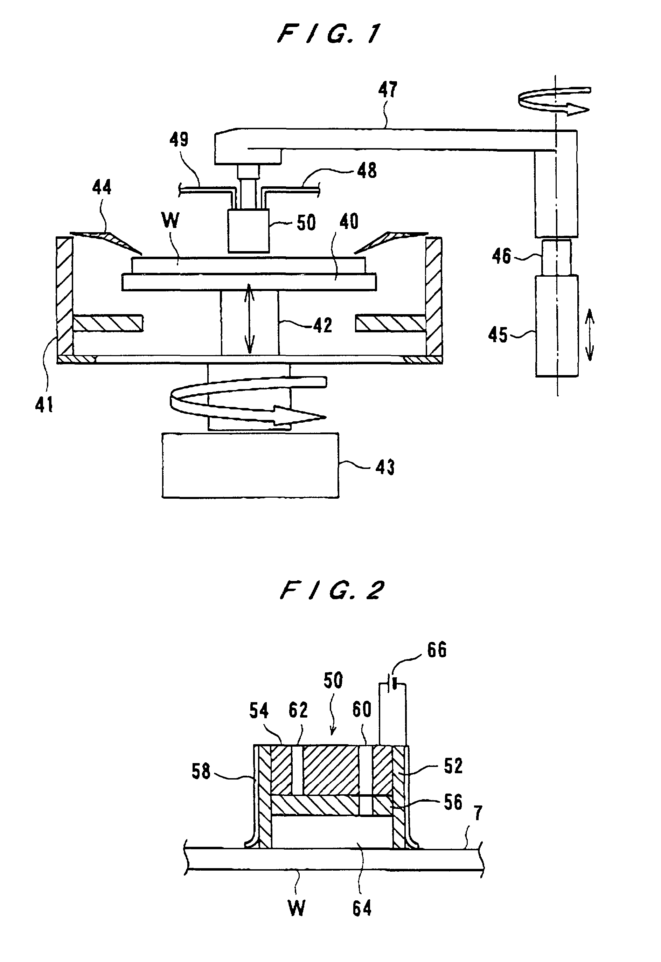

FIGS. 1 and 2 show a substrate plating apparatus according to a first embodiment of the present invention.

A substrate W such as a semiconductor substrate has a surface, to be plated, which has an interconnect trench 4 and a contact hole 3 for a circuit pattern and a seed layer 7 for electroplating which is deposited thereon, as shown in FIG. 11A.

The substrate plating apparatus according to the first embodiment of the present invention has a substrate holder 40 for holding the substrate W with the surface, to be plated, facing upwardly, and a housing 41 surrounding the substrate holder 40. The substrate holder 40 is vertically movable by a vertical cylinder 42 and rotatable about its own axis in unison with the housing 41 by a rotating motor 43. A seal ring 44 of an elastic material is mounted on the upper end of. the housing 41 and extends inwardly and downwardly. The substrate holder 40 which is holding the substrate W is elevated until the upper surface, to be plated, of the substrate W has its peripheral edge pressed against the seal ring 44. The seal ring 44 thus held against the substrate W prevents a plating liquid from being scattered around.

A swing arm 47 which is vertically movable by a vertical cylinder 45 and angularly movable by a swing motor 46 is positioned above the housing 41. The swing arm 47 supports a plating cell 50 suspended downwardly from a free end thereof. The plating cell 50 is connected to a plating liquid supply/discharge pipe 48 for supplying a plating liquid to the plating cell 50 and for discharging the plating liquid from the plating cell 50, and a gas discharge pipe 49 for discharging a gas from the plating cell 50.

As shown in FIG. 2, the plating cell 50 has a seal member 52 having a lower open end formed therein and a plate-like anode 54 disposed in an upper end portion of the seal member 52 in intimate contact with an inner circumferential surface of the seal member 52. A plating liquid holding member 56 made of a plate-like porous material such as a porous ceramic material is provided on the lower surface of the anode 54. A cathode electrode 58 is disposed on the circumferential surface of the seal member 52. The anode 54 and the plating liquid holding member 56 have a plating liquid supply/discharge hole 60 defined vertically therethrough for supplying and discharging the plating liquid. The plating liquid supply/discharge hole 60 is connected to the plating liquid supply/discharge pipe 48. The anode 54 also has a gas discharge hole 62 defined vertically therethrough for discharging a gas such as air from the inside of the seal member 52. The gas discharge hole 62 is connected to the gas discharge pipe 49.

In this embodiment, the sealing member 52 comprises a hollow square pole. The sealing member may comprise a member having surrounding walls such as cylindrical member.

When the lower open end of the plating cell 50 is pressed against the upper surface (the surface to be plated) of the substrate W under a given pressure, the lower tip end of the seal member 52 is hermetically contacted with the surface, to be plated, of the substrate W, forming a sealed space 64 within the seal member 52. At this time, the lower tip end of the cathode electrode 58 is electrically connected to the seed layer 7 on the surface, to be plated, of the substrate W.

While the tip end of the seal member 52 is being hermetically contacted with the surface, to be plated, of the substrate W, a metal plating liquid, e.g., a copper plating liquid, is supplied through the plating liquid supply/discharge hole 60. The gas such as air in the sealed space 64 is now discharged through the gas discharge hole 62, and the sealed space 64 is filled with the metal plating liquid. Then, a given DC plating voltage is applied from a plating power source 66 between the anode 54 and the cathode electrode 58, a plating current flows between the anode 54 and the seed layer 7 of the substrate W to form a plated metal film, e.g., a copper-plated film, on the surface area of the seed layer (the surface to be plated) 7 which confronts the sealed space 64.

As described above, the tip end of the seal member 52 of the plating cell 50 is contacted with the upper surface (the surface to be plated) of the substrate W, forming the small sealed space 64, and the plating liquid is introduced into the sealed space 64 for electrically plating the substrate W. The area surrounded by the tip end of the seal member 52 is made identical to the surface area, to be plated, of the substrate W, so that the plating liquid can be held in only the surface area, to be plated, of the substrate W to form a plated film on the surface area of the substrate W on which the plating liquid is held.

Since the plating liquid is sealed in the sealed space 64, the electric field intensity is not weak at the peripheral portion of the anode 54 unlike the conventional plating apparatus in which the anode and the substrate is disposed in facing relation to each other in the plating liquid. It is easy to uniformize the electric field intensity between the anode 54 and the seed layer 7 of the substrate W which faces the anode 54, making it easy to form a plated film of uniform thickness in only the surface area, to be plated, of the substrate W.

The plating liquid supply/discharge hole 60 is defined through the anode 54 and the plating liquid holding member 56, and the discharge hole 62 is defined through the anode 54. Consequently, when the metal plating liquid is supplied to the sealed space 64 in the sealing member 52 through the plating liquid supply/discharge hole 60, the gas such as air in the sealed space 64 is forced out through the discharge hole 62. The gas in the sealed space 64 can smoothly be replaced with the metal plating liquid. Since the gas is prevented from remaining in the metal plating liquid, a high-quality plated film can be formed on the substrate W.

The cathode electrode 58 is disposed on the circumferential surface of the seal member 52 and electrically connected to the seed layer 7 on the surface, to be plated, of the substrate W outside of the seal member 52. Therefore, the cathode electrode 58 is not exposed to the plating liquid. As a result, the cathode electrode 58 is prevented from being corroded by the plating liquid, and no plated metal film will be deposited on the surface of the cathode electrode 58.

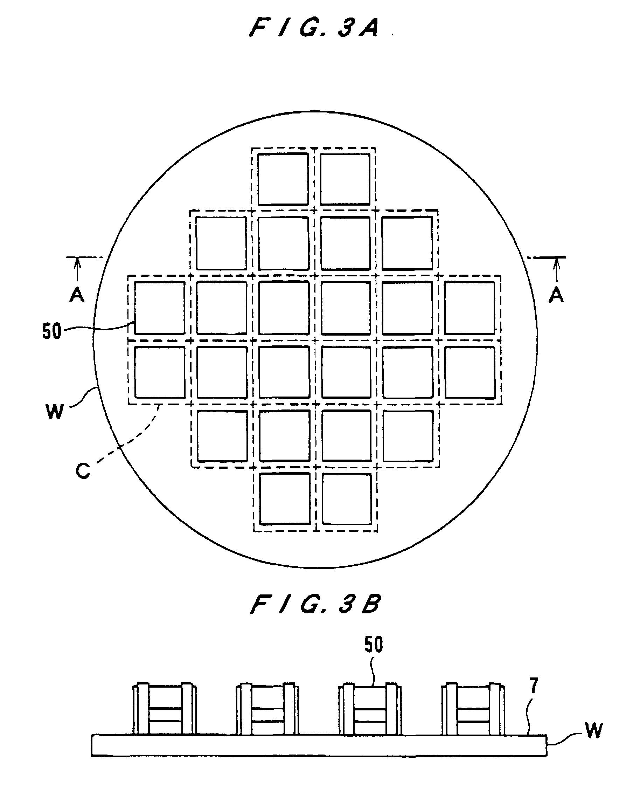

FIGS. 3A and 3B show a substrate plating apparatus according to a second embodiment of the present invention. FIG. 3A is a plan view, and FIG. 3B is a cross-sectional view taken along line A-A of FIG.3A. The substrate plating apparatus shown in FIGS. 3A and 3B has a number of plating cells 50. The plating cells 50 are arrayed in such a manner that the plating cells 50 face the surface, to be plated, of a substrate W which is typically a semiconductor substrate with semiconductor devices formed thereon. Each of the plating cells 50 has a sealing member 52 whose lower tip end is contacted with the substrate W around an area of a semiconductor chip C where trenches and holes of an interconnect pattern are formed (that is, an area which is required to be plated). The plating cells 50 are independent of each other such that plating currents can be supplied independently to the plating cells 50. In the second embodiment, the substrate W is supported by a substrate holder which is similar to the substrate holder 40 shown in FIG. 1.

Since the many plating cells 50 are arrayed on the surface, to be plated, of the substrate W, many areas of the surface, to be plated, of the substrate W can simultaneously be plated by the respective plating cells 50. In addition, the plating cells 50 are independent of each other such that plating currents can be supplied independently to the plating cells 50. Consequently, the thicknesses of the plated films deposited on the different areas of the surface, to be plated, of the substrate W can independently be adjusted as desired.

If the plating cell 50 has a large area, then the plating liquid cannot be held under surface tension of the plating liquid between the plating liquid holding member 56 and the surface, to be plated, of the substrate W. However, if the plating cell 50 has a small area, then the plating liquid can be held under surface tension of the plating liquid between the plating liquid holding member 56 and the surface, to be plated, of the substrate W.

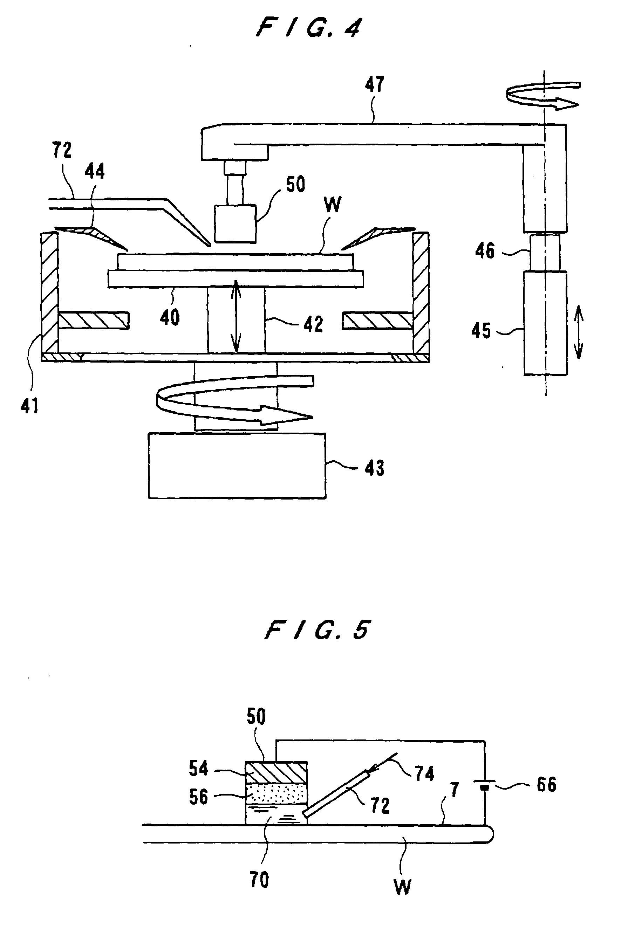

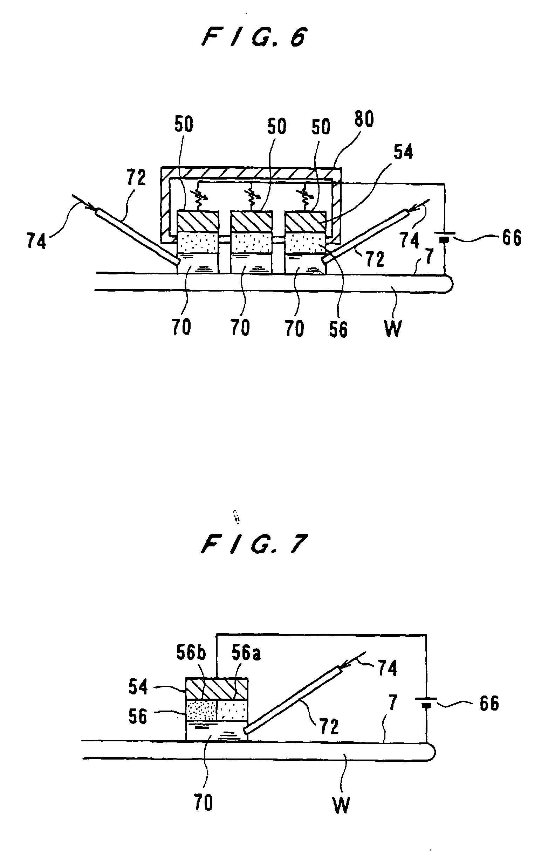

FIGS. 4 and 5 show a substrate plating apparatus according to a third embodiment of the present invention. According to the third embodiment, the plating liquid is held under surface tension of the plating liquid between the plating liquid holding member 56 and the surface, to be plated, of the substrate W. The substrate plating apparatus according to the third embodiment does not have a seal member around the plating liquid holding member 56, but has a plating cell 50 comprising an anode 54 and a plating liquid holding member 56 held in contact therewith. The distance between the plating liquid holding member 56 and the surface, to be plated, of the substrate W is kept within a predetermined range. When a plating liquid 74 is supplied from a plating liquid supply nozzle 72 to a space 70 formed between the plating liquid holding member 56 and the surface, to be plated, of the substrate W, the plating liquid 74 is held under surface tension in the space 70. Other structural details of the substrate plating apparatus according to the third embodiment are identical to the substrate plating apparatus shown in FIGS. 1 and 2.

As described above, the plating liquid 74 is held in the space 70 between the plating liquid holding member 56 and the surface, to be plated, of the substrate W, and the given voltage is applied from the plating power source 66 between the anode 54 and the seed layer (the surface to be plated) 7 of the substrate W to flow the plating current therebetween, thus forming a plated film in a desired area of the surface to be plated of the substrate W.

FIG. 6 shows a substrate plating apparatus according to a fourth embodiment of the present invention. In the substrate plating apparatus according to the fourth embodiment of the present invention, a plurality of plating cells 50 each free of a sealing member are held by a plating cell holder 80, and plating liquid supply nozzles 72 supply a plating liquid to a space 70 between each plating cell 50 and the surface, to be plated, of the substrate W to hold the plating liquid in the space 70. When a given voltage is applied from the plating power source 66 between the anode 54 of each plating cell 50 and the seed layer (the surface to be plated) 7 of the substrate W to flow the plating current therebetween, a plated film is formed in an area of the surface, to be plated, which confronts each plating cell 50. As with the arrangement shown in FIGS. 3A and 3B, the currents flowing through the respective plating cells 50 may be individually controlled to control the thicknesses of plated films in the respective plating cells 50.

While the plating liquid holding member 56 has been illustrated as being made of a single porous material, the plating liquid holding member 56 is not necessarily required to have a uniform porosity in its entirety. However, as shown in FIG. 7, the plating liquid holding member 56 may be made of a combination of a coarse porous material 56a and a dense porous material 56b. The plating liquid holding member 56 is not limited to a combination of two coarse and dense porous materials, but may be made of plural coarse and dense porous materials, which may be combined in a plurality of combinations. If plating cell 50 is constructed of a combination of plural coarse and dense porous materials, then the thickness of a plated film formed in an area of the surface, to be plated, of the substrate W which is confronted by the coarse porous material 56a may be increased, and the thickness of a plated film formed in an area of the surface, to be plated, of the substrate W which is confronted by the dense porous material 56b may be reduced.

By reducing the area of the plating cell 50, it is possible to control the thickness of the plated film on a semiconductor chip, partially. Such film thickness control can be used to correct a defective plated film or plate a limited area of the surface, to be plated, of the substrate W, for example. In the substrate plating apparatus shown in FIGS. 6 and 7, the substrate W is held by the substrate holder 40 (see FIGS. 1 and 4).

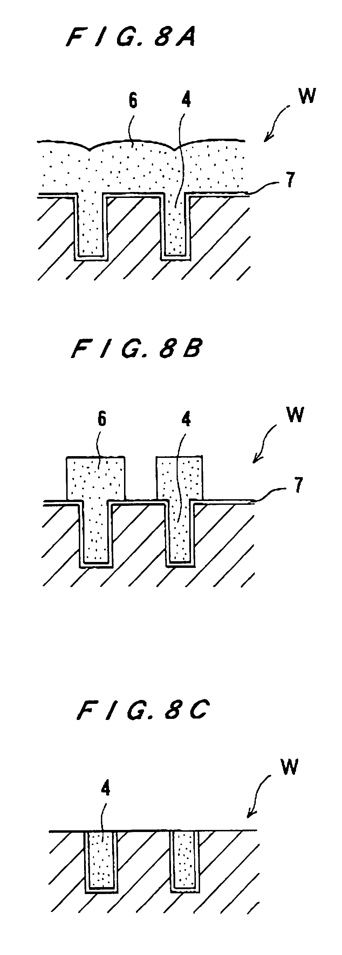

FIGS. 8A through 8C schematically show a comparison between a plated film formed by the conventional substrate plating apparatus and a plated film formed by the substrate plating apparatus according to the present invention. With the conventional substrate plating apparatus, as shown in FIG. 8A, a plated metal film (copper-plated film) 6 is formed on an entire surface of a substrate (semiconductor substrate) W including an area where interconnect trenches 4 of a circuit pattern are formed and an area where no interconnect trenches are formed, and thereafter the entire surface of the substrate W is polished to remove an excess metal layer to fill the interconnect trenches 4 with the plated metal film for thereby forming interconnections, as shown in FIG. 8C.

With the substrate plating apparatus according to the present invention, as shown in FIG. 8B, a plated metal film (copper-plated film) 6 can be formed in only an area where interconnect trenches 4 are formed. Since only such an area needs to be polished, the substrate W can be polished at an increased rate. In FIGS. 8A through 8C, the substrate W has a seed layer 7 for electroplating.

In the above embodiments, the formation of interconnections of a circuit pattern on a semiconductor substrate has been described. However, the substrate plating apparatus according to the present invention is not limited to the formation of interconnections of a circuit pattern on a semiconductor substrate, but may be used to form interconnections of a circuit pattern on a substrate by way of electroplating.

As described above, with the substrate plating apparatus according to the present invention, the plating liquid is introduced into the space formed between the surface, to be plated, of the substrate and the plating liquid holding member to perform electroplating. Therefore, the area of the plating liquid holding member is made identical to the surface area, to be plated, of the substrate, so that the plating liquid can be held in only the surface area, to be plated, of the substrate to form a plated film on the surface area of the substrate on which the plating liquid is held. Since the plating liquid is introduced into the space, it is easy to uniformize the electric field intensity between the anode and the surface, to be plated, of the substrate unlike the conventional plating apparatus in which the anode and the substrate is disposed in facing relation to each other in the plating liquid, thus making it easy to form a plated film of uniform thickness in only the surface area, to be plated, of the substrate.

By plating only the surface area that needs to be plated, it is easy to meet requirements for plating semiconductor wafers of larger diameters. Specifically, if a plating apparatus which is designed to plate the entire surface of a semiconductor wafer is used to plate semiconductor wafers of larger diameters, then the amount of electric power applied to the semiconductor wafers increases in proportion to the areas of the semiconductor wafers. For example, a plating process with a current density of 30 mA/cm² requires a total plating current of about 10 A for plating an 8-inch wafer, and a total plating current of about 20 A for plating a 12-inch wafer. Therefore, the plating apparatus which carries out such a plating process needs a power source capable of supplying an increasing plating current, and hence becomes large in size. However, the substrate plating apparatus according to the present invention is advantageous in that it can plate semiconductor wafers of larger diameters with one power source.

With a number of plating cells arrayed over the surface, to be plated, of the substrate, plated films can simultaneously be formed in many areas of the surface, to be plated, of the substrate.

Furthermore, since the small space is formed in such a manner that the plating cell face the surface, to be plated, of the substrate, and the plating liquid is introduced into the small area to plate the surface, to be plated, of the substrate, it is possible to form a plated metal film of uniform thickness in a desired area of the surface, to be plated, of the substrate.

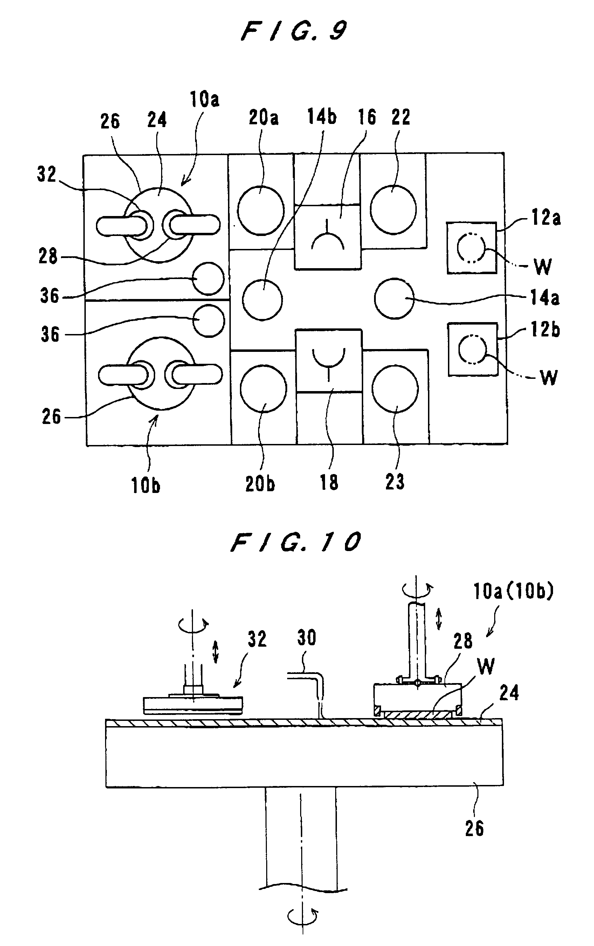

FIG. 9 shows a substrate processing system which incorporates a substrate plating apparatus according to the present invention. The substrate processing system has a pair of polishing apparatus 10a, 10b disposed on an end of a rectangular floor space and held in laterally facing relation to each other, and a pair of loading/unloading units disposed on the other end of the rectangular floor space for placing respective cassettes 12a, 12b each for housing a substrate W such as a semiconductor wafer or the like. Two transfer robots 14a, 14b are disposed on a transfer line interconnecting the polishing apparatus 10a, 10b and the loading/unloading units. Reversing devices 16, 18 are disposed both sides of the transfer line, respectively. First and second cleaning devices 20a, 22 are disposed in sandwiching relation to the reversing device 16, and a first cleaning device 20b and a substrate plating apparatus 23 according to the present invention are disposed in sandwiching relation to the reversing device 18. Vertically movable pushers 36 for transferring substrates W to and from the polishing apparatus 10a, 10b are disposed on the transfer line closely to the polishing apparatus 10a, 10b.

FIG. 10 shows each of the polishing apparatus 10a, 10b shown in FIG. 9. Each of the polishing apparatus 10a, 10b comprises a polishing table 26 with a polishing cloth (polishing pad) 24 applied to its upper surface to provide a polishing surface, and a top ring 28 for holding a substrate W with the surface, to be plated, thereof facing the polishing table 26. While the polishing table 26 and the top ring 28 are being rotated about their own axes, an abrasive liquid is supplied from an abrasive liquid nozzle 30 disposed over the polishing table 26, and the top ring 28 presses the substrate W under a constant pressure against the polishing cloth 24 on the polishing table 26 to polish the surface of the substrate W. The abrasive liquid supplied from the abrasive liquid nozzle 30 comprises a suspension of fine particles of silica or the like in an acid solution. When the abrasive liquid is supplied, it oxidizes the surface of the substrate W and thereafter the abrasive grain particles mechanically polishes the substrate W to a flat mirror finish.

As the polishing apparatus 10a, 10b continuously carry out their polishing process, the polishing capability of the polishing surface of the polishing cloth 24 is lowered. In order to recover the polishing capability of the polishing cloth 24, the polishing cloth 24 is dressed by a dresser 32 as when the substrate W is replaced. In the dressing process, the dressing surface (dressing member) of the dresser 32 is pressed against the polishing cloth 24 on the polishing table 26 and the dresser 32 and the polishing table 26 are rotated about their own axes to remove the abrasive liquid and scraped substrate particles or fragments from the polishing surface of the polishing cloth 24 and planarize and dress the polishing surface, thus regenerating the polishing surface. The dressing process may be performed on the polishing surface while the substrate W is being polished by the polishing surface.

A process of plating copper to form a copper interconnection in a desired area of the surface of the substrate W with the seed layer 7 formed thereon, as shown in FIG. 11A, using the substrate plating apparatus 23 of the substrate processing system will be described below. Since the two polishing apparatus 10a, 10b carry out the same polishing process in parallel, the substrate W flows in the same manner on the two polishing apparatus. Therefore, only one polishing apparatus will be described below.

First, a substrate W taken out from the cassette 12a (12b) in the loading/unloading unit by the first transfer robot 14a is introduced into the substrate plating apparatus 23, which forms a copper film 6 (see FIG. 11B) on a portion of the substrate W. While the substrate W with the copper film 6 formed thereon is being held by the substrate holder of the substrate plating apparatus 23, the surface of the substrate W is rinsed or cleaned, and then spin-dried, if necessary. The substrate W is then transferred by the first transfer rotor 14a to the reversing device 16, which reverses the substrate W. The reversed substrate W is then transferred onto one of the pushers 36 by the second transfer robot 14b. The top ring 28 attracts the substrate W off the pusher 36, moves the substrate W above the polishing table 26, and is lowered to press the surface to be polished of the substrate W against the polishing cloth 24 on the rotating polishing table 26 under a given pressure to polish the substrate W while the abrasive liquid is being supplied thereto.

The polished substrate W is returned onto the pusher 36 by the top ring 28 and then cleaned by a spray of pure water. The substrate W is then transferred by the second transfer robot 14b to the primary cleaning device 20a, and cleaned in a primary mode by the primary cleaning device 20a. The cleaned substrate W is transferred to the reversing device 16 and reversed thereby, after which the substrate W is transferred by the first robot 14a to the secondary cleaning device 22. After the substrate W is cleaned in a secondary mode by the secondary cleaning device 22, the substrate W is spin-dried at a high rotation speed, and then returned to the cassette 12a (12b) by the first transfer robot 14a.

Although certain preferred embodiments of the present invention have been shown and described in detail, it should be understood that various changes and modifications may be made therein without departing from the scope of the appended claims.

## Claims

1. A plating apparatus for plating a substrate, comprising:
a substrate holder for holding a substrate; and
a plating cell for plating a portion of a surface, to be plated, of the substrate held by said substrate holder;
wherein said plating cell comprises:
an anode disposed so as to cover the portion of the surface, to be plated, of the substrate held by said substrate holder;
a cathode for supplying a current to the surface, to be plated, of the substrate in such a state that said cathode is brought into contact with the substrate;
a plating liquid supplying device for supplying a plating liquid between said anode and the surface, to be plated, of the substrate; and
a power source for applying a voltage between said anode and said cathode.

2. The plating apparatus according to claim 1,
wherein said plating cell further comprising a plating liquid holding member provided on a lower surface of said anode.

3. The plating apparatus according to claim 2,
wherein said plating liquid holding member comprises a plate-like porous material.

4. The plating apparatus according to claim 2,
wherein said plating liquid holding member comprises a plurality of porous materials combined with each other.

5. The plating apparatus according to claim 3,
wherein said plating cell further comprising a sealing member having a opening formed therein;
wherein said anode and said plating liquid holding member are disposed within said sealing member, and a sealed space surrounded by said sealing member is formed when said lower opening end is pressed against the surface, to be plated, of the substrate.

6. The plating apparatus according to claim 5,
wherein said cathode electrode is disposed on the outer circumferential surface of said sealing member.

7. The plating apparatus according to claim 5,
wherein said plating liquid supplying device has a plating liquid supply/discharge hole defined through said anode and said plating liquid holding member, and communicated with said sealed space.

8. The plating apparatus according to claim 5,
wherein said anode has a discharge hole defined therein for discharging a gas from said sealed space.

9. The plating apparatus according to claim 2,
wherein said plating liquid holding member is positioned so as to hold the supplied plating liquid between said plating liquid holding member and the surface, to be plated, of the substrate, under surface tension of the plating liquid.

10. The plating apparatus according to claim 9,
wherein said plating liquid holding member comprises a plate-like porous material.

11. The plating apparatus according to claim 9,
wherein said plating liquid holding member comprises a plurality of porous materials combined with each other.

12. The plating apparatus according to claim 2,
wherein said plating liquid supplying device has a plating liquid supply nozzle for supplying the plating liquid between said plating liquid holding member and the surface, to be plated, of the substrate.

13. The plating apparatus according to claim 1,
wherein a plurality of plating cells are arrayed in such a manner that said plating cells face the surface, to be plated, of the substrate.

14. The plating apparatus according to claim 13,
further comprising a plating cell holder for holding said plating cells in common.

15. The plating apparatus according to claim 13,
wherein each of said plating cells is arranged so as to individually control a plating current flowing between said anode and the surface, to be plated, of the substrate facing said anodes.

16. A plating method for plating a substrate, comprising:
covering a portion of a surface, to be plated, of the substrate with an anode;
holding a plating liquid between said anode and the surface, to be plated, of the substrate; and
applying a voltage between said anode and the surface, to be plated, of the substrate to plate said portion of the surface, to be plated, of the substrate covered with said anode.

17. The plating method according to claim 16,
wherein a plating liquid holding member is held on a lower surface of said anode.

18. The plating method according to claim 17,
wherein said plating liquid holding member comprises a plate-like porous material.

19. The plating method according to claim 17,
wherein said plating liquid holding member comprises a plurality of porous materials combined with each other.

20. The plating method according to claim 17,
wherein said anode and said plating liquid holding member are disposed within a sealing member having a opening formed therein, and the plating liquid is held in a sealed space formed by said lower opening end which is pressed against the surface, to be plated, of the substrate.

21. The plating method according to claim 17,
wherein said plating liquid holding member is disposed in close proximity to the surface, to be plated, of the substrate to hold the plating liquid under surface tension between said plating liquid holding member and the surface, to be plated, of the substrate.
